# EUROPEAN PATENT APPLICATION

(11) **EP 1 780 783 A1**
(43) Date of publication of application: **02.05.2007**
(21) Application number: 06020386.6
(22) Date of filing: 28.09.2006
(51) Int. Cl.: H01L 21/607, H01L 23/485, C23G 5/00

(54) **Methods for protecting metal surfaces**

(30) Priority: 29.09.2005 US 722609 P; 14.10.2005 US 727211 P
(71) Applicant: Interuniversitair Microelektronica Centrum, 3001 Leuven (BE)
(72) Inventor: Soussan, Philippe, 3000 Leuven (BE); Stoukatch, Serguei, 3001 Leuven (BE); Beyne, Eric, 3001 Leuven (BE)
(74) Representative: Bird, William Edward

(57) **Abstract**

The present invention provides methods for protecting metal surfaces against oxidation. The methods may comprise a plasma treatment, a sintering treatment or a combination of the plasma and sintering treatment. The present invention also provides a method for bonding a wire on a metal bond pad using any of the methods for protecting a metal surface according to the present invention.

## Description

### Field of the invention

The present invention relates to methods for protecting a metal surface against oxidation and to a method for bonding wires to metal bond pads using the methods for protecting a metal surface. A typical application domain is the field of bonding metal bonding wires to metal bond pads in e.g. microelectronics technology.

### Background of the invention

In high-performance and advanced semiconductor devices, the trend toward copper metallization is progressing. Implementation of copper instead of aluminium as interconnect material increases the integrated circuit performance and reduces electromigration phenomenon. Similarly, copper and copper based alloys are replacing aluminum as the material for bond pad's finish metallization, because of their outstanding properties.
A general treatment used to prepare or protect copper surfaces for further processing is to perform an annealing in chemically reducing atmospheres (e.g. forming gas (N₂/H₂)). This technique restores the pure copper surface by reducing the copper oxide present at the copper surface. However, the surface will re-oxidize when exposed to oxidizing ambient afterwards.
Copper and copper based alloys already oxidize in air at room temperature. Thermal exposure, which is a common attribute for wire bonding, makes this even worse. In these cases, the oxide continues to grow in thickness on the copper bond pad. Therefore, the condition of the copper surface is a crucial factor for successfully performing a wire bonding process. With successful wire bonding process is meant that after bonding the wire to the bond pad, a tight contact is obtained between the wire and the bond pad. To achieve successful wire bonding on copper bond pads, it is necessary to protect the top surface of the pads from oxidation.

For providing a pure Cu surface in advanced microelectronics, mainly three different approaches are being used today.

One approach consists of a physical protection of copper, realized by coating the copper surface by materials that are not sensitive to oxidation and that exhibit good diffusion barrier properties towards oxidizing elements (more details below).

A second approach consists of physically removing copper oxides present at the copper surface by e.g. Chemical etching in hydrochloric acid (HCl) or acetic acid (CH₃CO₂H) which have proved to selectively etch the copper oxide without attacking the underlying copper surface. Because copper is very sensitive to oxidation in the presence of water, dry techniques are usually preferred. Argon based plasma processes are commonly used for this purpose. This technique removes the copper oxides, and possibly also the copper itself depending on the etch time, by means of sputtering phenomena. It further activates the surface and is commonly used in wire bonding to increase adhesion of a bond wire to a bond pad. Due to the re-oxidation process of the surface, wire bonding performance is reduced over time, which means that surfaces need to be processed within a 15 minutes process window.

A third approach consists in chemically reducing the copper oxides, which is achieved by exposing the oxidized copper surface to reducing agents. Ethanol vapour or ethyl alcohol are efficiently used for this purpose. Similarly, plasmas in forming gases are commonly used. Such techniques in fact combine a chemical reaction, i.e. the reduction of copper oxide, with a physical removal, which is inherent to ionic bombardment of the substrate by energetic particles. They can be performed at room temperature with a limited success.

In the second and third approach, one is always limited by the re-oxidation process that occurs naturally to the pure copper surface.

In wire bonding technology, the copper bond pad needs to be protected from oxidation. This can be achieved with various techniques, such as metallurgical capping (the most known among them, are Ni/Au, Ni/Pd/Au and Al), thin organic films (self assembled mono layer, OSP: known as organic surface preservative), thin inorganic films (SiC or thin titanium passivation layer), or plasma cleaning technique directly prior to wire bonding. All these methods have several disadvantages:

Metal caps provide the best known results up till now for the protection of copper surfaces against oxidation. However, these metal caps introduce an additional interface on top of the copper bond pads. This minimizes the electrical performance improvement gained by replacing aluminum bond pad metallization by copper metallization. In addition, it may cause significant reliability deterioration. The application of these metal caps is done by plating or vacuum deposition techniques, which increase the wafer fabrication lead-time and make the end product very expensive.

The use of thin organic films for copper oxidation protection is a relatively cheap and simple process. The most successful among them is the application of self-assembled monolayers (SAMs). SAMs are easy to apply at wafer level by spinning or dipping techniques, but the wafer comprising e.g. a copper surface needs to be conditioned by a wet cleaning process before the application of the SAM. SAM layers are very thin (below 50 nm thick) and soft, and can easily be removed by ultrasonic power during thermosonic (TS) wire bonding, ultimately resulting in a good bonding performance. However, the method has several drawbacks, the main one being the limited stability with respect to thermal exposure.

Thin inorganic films are also used for copper oxidation protection (e.g. SiC, SiO, SiON or "thin titanium passivation layer"). In general, these layers provide sufficient copper protection against oxidation. However, in many cases the passivation layer cannot be removed by ultrasonic power during thermosonic wire bonding or requires excessive ultrasonic power that, as was reported, may damage the soft and sensitive low-k dielectric, which may be present underneath.

In order to prevent the copper surface from oxidation, it is possible to use thermosonic wire bonding to bare copper by use of an inert gas environment. The inert gas environment, usually argon or nitrogen, is applied locally onto the bonding area and creates a shielding atmosphere to protect copper surfaces against oxidation, which enables and secures a stable wire bonding process within 5 to 20 minutes.

In US 6,720,204 B2, a method of bonding a wire to a metal bond pad is disclosed, comprising the following steps. A semiconductor die structure having an exposed metal bond pad is provided within a chamber. The bond pad has an upper surface. A hydrogen-plasma is produced within the chamber from a plasma source. The metal bond pad is pre-cleaned and passivated with the hydrogen-plasma to remove any metal oxide formed on the metal bond pad upper surface. A wire is then bonded to the passivated metal bond pad while the metal bonding path is within the hydrogen comprising plasma. Fig. 1 illustrates a tool for performing the method according to US 6,720,204 B2. The tool comprises a plasma tool 102, a bonding tool 104 and a transfer mechanism 106 by which a wafer is transported between the plasma tool 102 and the bonding tool 104. The plasma tool 102, bonding tool 104 and transfer mechanism 106 are located in an enclosure 100 which is purged with N₂, which forms a non-oxidizing environment for preventing oxidation of the bond pads during transportation of the semiconductor die structure from the plasma tool 102 to the bonding tool 104.

### Aim of the invention

It is an aim of the invention to provide a good method for protecting a metal surface against oxidation which alleviates or avoids the problems of the prior art. The method enables long term prevention of oxidation of surfaces comprising metals and metal alloys such as e.g. copper or copper based alloys, enabling further processing without suffering from the presence of a metal oxide, e.g. copper oxide.
It is a further aim of the invention to provide a method for wire bonding on metal bond pads, such as e.g. Cu bond pads, at large scale.

### Summary of the invention

Aspects of the present invention provide methods for treating or protecting metal surfaces against oxidation. Such a metal surface can be, for instance, a metal bond pad on a semiconductor device, on which e.g. a wire needs to be bond for electrically connecting the semiconductor device with components external to the semiconductor device. Methods for cleaning, passivation and protection of such a surface, which allow further processing of the metal surface without suffering from oxidation, are also provided. For example, bonding of wires onto the metal surface may be possible at a later stage, especially after placing the metal surfaces in an oxidizing environment as, for instance, air without oxidation of the metal surface.

In a first aspect of the present invention, a method for protecting a metal surface is disclosed, comprising the steps of
providing the metal surface within a plasma chamber;
producing a hydrogen comprising plasma within the plasma chamber,
treating the metal surface with the hydrogen comprising plasma whereby the metal surface is at a temperature above 150°C for completely removing oxides present at the metal surface and for hydrogenating the metal surface; and
removing the metal surface from the plasma chamber into an oxidising environment.
The method according to the first aspect of the present invention allows bringing the treated metal surfaces outside the plasma chamber, e.g. in an oxidizing environment or ambient air, for a significant amount of time, without oxidation of the metal surface occurring and thus after which further processing, e.g. wire bonding, can still be successfully performed without any oxidation removal steps being necessary. This offers an additional degree of freedom in production processes and a wide range of new production possibilities. For instance, metal surfaces treated according to the method of the first aspect of the invention can be stored in air for a while or can be transported outside a non-oxidising atmosphere without oxidation of the metal surface.

According to certain embodiments the metal surface may comprise Cu or Ag. According to preferred embodiments of the first aspect of the present invention, the temperature of the metal surface may be brought to a temperature within the range of between 30°C and 400°C, more preferably between 70°C and 300°C, even more preferably between 125°C and 200°C or between 150°C and 400°C, preferably between 150°C and 300 °C and more preferably between 150°C and 300°C, while treated or before being treated with the hydrogen comprising plasma. According to certain embodiments the metal surface can be put on a heatable chuck when in the plasma chamber, which may reduce the process duration.
According to preferred embodiments of the first aspect of the present invention, the plasma gas for forming the hydrogen comprising plasma may comprise H₂ and/or NH₃. The fraction of plasma gas comprising H₂ and/or NH₃ is preferably between 100% and 20%, more preferably between 90% and 70%.
According to preferred embodiments of the first aspect of the present invention, the plasma gas may comprise N₂, O₂, Ar or He, or other noble gases, or a combination of the aforementioned gases. The fraction of plasma gas comprising N₂, O₂, Ar or He, or other noble gases or a combination of the aforementioned gases is between 0% and 30%, preferably between 10 and 30%.
The method according to embodiments of the present invention allows the metal surface to be stored in an oxidising environment for a period of more than 1, 8, 12, 24, 48 hours.
According to preferred embodiments of the first aspect of the present invention, a hydrogen comprising plasma may be generated by an Inductively coupled Plasma - Reactive ion etching or ICP-RIE tool. According to preferred embodiments of the first aspect of the present invention, power supplied to a coil used in the ICP-RIE tool, also called ICP parameter, may be between 300 to 1000 W. According to preferred embodiments of the first aspect of the present invention, the direct power or RIE parameter may be between 50 to 250 W.

In preferred embodiments of the first aspect of the present invention, the hydrogen comprising plasma may be generated by microwave downstream plasma equipment.
According to preferred embodiments of the first aspect of the present invention, wherein the Microwave power (for downstream plasma) may be between 200 and 3000 W.
According to preferred embodiments of the first aspect of the present invention, treating the metal surface with a hydrogen comprising plasma may have a duration of between 30 and 120 seconds, preferably between 60 and 120 seconds.
According to preferred embodiments of the first aspect of the present invention, injection of gas into the plasma chamber for forming the hydrogen comprising plasma may be between 50 sccm and 600 sccm.

In a second aspect of the present invention, a method of bonding a wire to an exposed metal bond pad on a wafer is disclosed, comprising the steps of:
treating the metal bond pad according to any of the methods for protecting a metal surface according to the present invention; and
bonding a wire to the treated metal bond pad after having moved the wafer into an oxidising environment.
The method according to the second aspect of the present invention allows bringing the semiconductor die structure or wafer outside the plasma chamber, e.g. in an oxidising environment or ambient air, for a significant amount of time, without oxidation of the metal surface occurring and thus after which further processing, in this aspect of the invention wire bonding, can still advantageously be performed. This offers an additional degree in production processes and a wide range of new production possibilities. For instance, semiconductor die structures or wafers comprising a metal surface treated according to the method of the invention can be stored in air for a while or can be transported without oxidation of the metal surface.
According to preferred embodiments of the second aspect of the present invention, the metal bond pad may comprise a material selected from the group comprising Al, Al-Cu and Cu, and the wire may comprise a material selected from the group comprising Au, a copper alloy and copper.
According to preferred embodiments of the second aspect of the present invention, the metal bond pad may comprise Cu and the wire may comprise Au, Cu or Ag.
According to preferred embodiments of the second aspect of the present invention, the wire may be Cu coated with Au, Cu coated with Pd, Cu coated Ag.
In preferred embodiments of the second aspect of the present invention, the plasma source may be a direct plasma source.
According to preferred embodiments of the second aspect of the present invention, the direct plasma source may be formed by a parallel plate with RF.
According to other embodiments of the second aspect of the present invention the plasma source may be downstream.
According to preferred embodiments of the second aspect of the present invention the hydrogen source may be selected from the group consisting of NH₃, H₂, N₂+H₂, He+H₂, and Ar+H₂.
According to certain embodiments of the second aspect of the present invention, the method may comprise a further step of masking the semiconductor die structure or wafer to expose the metal bond pad before the hydrogen-plasma production step.
In a third aspect of the present invention (also called sintering aspect), a method for protecting a metal surface is disclosed comprising the steps of
providing a substrate comprising a metal surface in a chamber of an oven,
heating the substrate to a temperature in the range of 150°C to 600°C, more preferably in the range of 300°C to 500°C, more preferably in the range of 400°C to 450°C in a reducing gas atmosphere (also called sintering), and
removing the substrate from the chamber into an oxidizing environment.
According to preferred embodiments of the third aspect of the present invention, the reducing gas may comprise H₂, N₂, Ar or He, or other inert gases, or may comprise ammonium plasma (NH₃) or any other gas or gas composition comprising free hydrogen (H₂) or chemically bonded hydrogen (H). Most preferably the reducing gas may be forming gas and may comprise, for example, 4% H₂/N₂, 5% H₂/N₂, 10% H₂/N₂. Also other gas compositions such as, for example, gas compositions comprising 4% H₂/Ar, 5% H₂/Ar or 10% H₂/Ar can be used.
According to preferred embodiments of the third aspect of the present invention the reducing gas may comprise only H₂ and N₂.
According to preferred embodiments of the third aspect of the present invention the amount of N₂ may be between 98 % and 0%. Preferably, the amount of N₂ may be between 98 % and 50 %.
According to preferred embodiments of the third aspect of the present invention the amount of H₂ may be between 2% and 30%, or between 2% and 20%, or between 2% and 15%, or between 2% and 10%.
According to preferred embodiments of the third aspect of the present invention the metal surface may stored in an oxidising environment for a period of more than 8, 12, 24, 48 hours.
According to preferred embodiments of the third aspect of the present invention, the oven may be an RTP oven.
According to preferred embodiments of the third aspect of the present invention, heating the substrate may have a duration between 5 and 60 minutes, more preferably between 10 and 60 minutes, even more preferably 15 to 25 minutes.

In a fourth aspect of the present invention a method for protecting a metal surface is disclosed, comprising:
treating the metal surface according to the third aspect (sintering aspect) of the present invention, and
treating the metal surface according to the first aspect of the invention (corresponding to a plasma aspect).
The present invention also provides the use of the methods for protecting a metal surface in the manufacturing of semiconductor devices.

### Description of the figures

Fig. 1 Illustrates a tool configuration for performing a method according to the prior art (US 6720204B2).
Fig. 2 is an Illustration of an embodiment of a device according to the present invention.
Fig. 3 illustrates an embodiment of a device according to the present invention.
Fig. 4, Fig. 5 and Fig. 6 demonstrate the wire bonding (WB) performance on a set of wafers subjected to series of different plasma treatments or temperature step (sintering) treatments.

### Description of illustrative embodiments

The present invention will be described with respect to particular embodiments and with reference to certain drawings but the invention is not limited thereto but only by the claims. The drawings described are only schematic and are nonlimiting. In the drawings, the size of some of the elements may be exaggerated and not drawn on scale for illustrative purposes. The dimensions and the relative dimensions do not correspond to actual reductions to practice of the invention.
It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

The embodiments of the present invention may be used in any field where metal, as for instance copper, based metallization needs to be protected against oxidation caused by effect of various factors (such as e.g. ambient environment and exposure to elevated temperature).

The present invention provides methods for protecting metal surfaces against oxidation. The methods according to embodiments of the invention reduce metal oxides present at the metal surface by means of a treatment of the metal surface such that, after the treatment, the metal surface is protected against re-oxidation for a certain period of time, even when exposed to an oxidising environment such as e.g. ambient air.
The present invention furthermore provides a method for bonding wires on metal bond pads on a wafer. The method comprises pre-treatment of the surface of the wafer using the methods for protecting metal surfaces according to embodiments of the present invention followed by bonding wires onto the protected metal bond pads.
Typical applications of the methods according to the present invention can be found in the field of metal protection, e.g. copper or copper based alloys protection, of integrated circuits and other components, devices and printed circuit boards (PCB, PWB). The methods may be used during manufacturing of any device where metal, e.g. copper, surface post processing is required (such as wire bonding, soldering, gluing and others).

In the following description the methods according to the invention will be described for metal bond pads comprising copper. Other metals, however, are though not excluded and can also be used with the present invention, such as for instance any copper alloy or Ag. Furthermore, the invention will be described for the bonding wire metal being gold. Again, also here other metals are not excluded and may be used with the present invention, such as for example Cu, Al, Ag, Pd or any combination of suitable materials such as for example Cu wires coated with Au, Pd or Ag. Table 1 shows some combinations of materials suitable to be used with the present invention. It has, however, to be understood that these combinations are only examples and are not intended to limit the invention in any way.

**Table 1: suitable combinations of metals for forming the bond pad and the wires.**

| Pad metal | Wire metal |
|---|---|
| Cu | Au |
| Cu | Cu |
| Cu | Cu coated with Au, Pd, Ag |
| Cu | Ag |

In a first aspect of the present invention, methods for protecting a metal surface, e.g. copper surface, against oxidation are provided. The metal, e.g. copper, surface treatment techniques according to the present invention restore the oxidized metal surface to a pure metal, e.g. copper, surface and protect it from re-oxidation. This can be achieved in different ways and by different embodiments :
A// In a first embodiment a high density, H₂ (hydrogen) rich or hydrogen comprising plasma is applied to the metal surface present on e.g. a wafer. When the wafer temperature is above 150°C the reduction process is complete, or in other words all forms of copper oxides are reduced/removed. Furthermore, above 150°C the surface is implanted with hydrogen ions which makes it less sensitive to oxidation over a subsequent period of time, as proved by successful wire bonding tests performed at 150°C.
B// According to a second embodiment a sintering step can be applied, i.e. a temperature step in a reducing gas ambient, which comprises hydrogen. The reducing gas may comprise H₂, N₂, Ar or He, or other inert gases, or may comprise ammonium plasma (NH₃) or any other gas or gas composition comprising free hydrogen (H2) or chemically bonded hydrogen (H). Most preferably the reducing gas may be forming gas and may comprise, for example, 4% H₂/N₂, 5% H₂/N₂, 10% H₂/N₂. Also other gas compositions such as, for example, gas compositions comprising 4% H₂/Ar, 5% H₂/Ar or 10% H₂/Ar can be used.
C// According to a third embodiment a combination of both techniques described in A// and B// can be applied. According to these embodiments, a sintering step can be followed by a plasma treatment or vice versa.

According to a first embodiment of the invention, a method is provided for protecting a metal surface against oxidation, the method comprising providing the metal surface within a plasma chamber, producing a hydrogen comprising or hydrogen rich plasma within the plasma chamber, treating the metal surface with the hydrogen comprising or hydrogen rich plasma whereby the metal surface is at a temperature above 150°C for removing oxides, optionally completely removing oxides present at the metal surface and for hydrogenating the metal surface, and removing the metal surface from the plasma chamber into an oxidising environment.

According to the first embodiment of the present invention, the temperature of the metal surface is brought to a temperature within the range of between 30°C and 400°C, more preferably between 70°C and 300°C, even more preferably between 125°C and 200°C or between 150°C and 400°C, preferably between 150°C and 300 °C and more preferably between 150°C and 300°C while treated or before being treated with the hydrogen comprising plasma. In certain embodiments the metal surface can be put on a heatable chuck when in the plasma chamber, which may reduce the process duration.

The hydrogen comprising plasma may be generated by, for example, an Inductively coupled Plasma - Reactive ion etching or ICP-RIE tool. The power applied to the coil of the ICP-RIE tool, also called ICP parameter, may be between 300 to 1000 W and the direct power or RIE parameter may be between 50 to 250 W. According to other embodiments, the hydrogen comprising plasma may be generated by microwave downstream plasma equipment. The microwave power for downstream plasma may be between 200 and 3000 W.

According to the first embodiment of the present invention, the hydrogen comprising or hydrogen rich plasma may comprise a small amount of another gas, for example may comprise 10% of e.g. N₂. This N₂ gas or other gases such as e.g. O₂, Ar or He, or other noble gases which can be used in embodiments according to the present invention and the molecules of which easily dissociate in the plasma, helps the dissociation of H₂ gas into hydrogen ions, which are much more reactive towards the metal, e.g. copper, surface. In addition to the reducing action of the hydrogen comprising or hydrogen rich plasma on the metal oxide, e.g. copper oxide, surface, it may be pointed out that such hydrogen comprising plasma also eliminates fluorines (CF₄, SF₆,...), which are well know to trigger metal corrosion, e.g. copper corrosion, from the surface. It results in a significant improvement of metal, e.g. copper, surface cleanliness.

In case of a H₂/N₂ plasma, the gas flow of the gas in the plasma chamber may, according to embodiments of the invention, be 200 sccm for H₂ and 20 sccm N₂, at a pressure of 10 mT, and 600 W ICP, 75W Bias(plate). The process time or the time the metal, e.g. copper, surface is exposed to the hydrogen comprising or hydrogen rich plasma may be varied between 10 to 120 seconds. Preferably, a process time of 30 to 120 seconds or of 60 to 120 seconds may be applied.

According to other embodiments of the present invention, a H₂/O₂ plasma may be used to clean and passivate the metal, e.g. Cu, surface and protect the metal, e.g. copper, surface against oxidation. According to these embodiments, the gas flow may be 200 sccm for H₂ and 20 sccm for O₂, at a pressure of 10 mT, and a power of 600 W ICP, 75W Bias (plate), for a process time of between 10 to 120 seconds, 30 to 120 seconds or of 60 to 120 seconds.

The process according to the first embodiment of the present invention reduces metal oxides, e.g. copper oxides, present at a metal surface. Basically, this means that the reducing agent, which according to the first embodiment of the present invention is formed by the hydrogen ions in the hydrogen comprising or hydrogen rich plasma, convert the metal oxide, e.g. copper oxide, back to pure metal, e.g. pure copper. The process simultaneously hydrogenates the copper surface (depth of hydrogenation will mainly depend on power and duration of the plasma treatment) and modifies the surface. This may be explained by hydrogen diffusing into the grain boundaries, and acting later as a barrier toward oxygen, hereby preventing the metal, e.g. Cu, from oxidizing when exposed to oxidizing environment. However the hydrogen ions may also diffuse into the grains. As a result, a long-term oxidation prevention may be obtained which allows storage of the metal surface in normal or ambient atmosphere (comprising e.g. air). This provides an extra degree of process freedom when compared to the prior art, since transportation and waiting cycles between metal, e.g. Cu, surface exposure and further processing such as e.g. wire bonding, are allowed. It is notable that preferably the wire bonding is performed in air at a temperature between room temperature and 250°C, more preferably between 100°C and 250°C during die attach and thermosonic wire bonding (see further).

The method according to the first embodiment of the present invention exhibits several added value features compared to known plasma cleaning and passivation processes prior to wire bonding. Instead of just removing/reducing the oxide, the method according to the first embodiment of the present invention furthermore modifies and conditions the bare metal, e.g. copper, surface. The mechanism of such surface treatment is complex and comprises at least a combination of chemical reactions and physical interactions between the metal, e.g. copper, surface and the hydrogen comprising plasma.

According to a second embodiment of the present invention, an alternative method is provided for protecting a metal surface. The method comprises the steps of providing a wafer or substrate comprising a metal surface in a chamber of an oven, heating the wafer or substrate to a temperature in the range of 150°C to 600°C, more preferably in the range of 300°C to 500°C , still more preferably in the range of 400°C to 450°C in a reducing gas atmosphere; (also called sintering) and removing the wafer or substrate from the chamber into an oxidising environment.

According to embodiments of the present invention, the reducing gas may comprise H₂, N₂, Ar or He, or other inert gases, or may comprise ammonium plasma (NH₃) or any other gas or gas composition comprising free hydrogen (H₂) or chemically bonded hydrogen (H). Most preferably the reducing gas may be forming gas and may comprise, for example, 4% H₂/N₂, 5% H₂/N₂, 10% H₂/N₂. Also other gas compositions such as, for example, gas compositions comprising 4% H₂/Ar, 5% H₂/Ar or 10% H₂/Ar can be used.

According to embodiments of the invention, the reducing gas may be forming gas and the amount of N₂ in the forming gas may be between 98% and 0%. Preferably, the amount of N₂ may be between 98 % and 50 %. The amount of H₂ may be between 2% and 30%, or between 2% and 20%, or between 2% and 15%, or between 2% and 10%.

According to embodiments of the invention, the oven may be a rapid thermal processing or RTP oven. The temperature step, i.e. the heating of the wafer or substrate, may have a duration of between 10 and 60 minutes, between 50 and 60 minutes or between 15 and 25 minutes.

Similarly to the process according the first embodiment of the invention, the process according the second embodiment of the present invention reduces metal oxides, e.g. copper oxides, present at a metal surface. Basically, this means that the reducing agent, which according to the second embodiment of the present invention is formed by the hydrogen ions in the reducing gas, e.g. by the hydrogen ions in the forming gas, convert the metal oxide, e.g. copper oxide, back to pure metal, e.g. pure copper. The process simultaneously hydrogenates the copper surface (depth of hydrogenation will mainly depend on power and duration of the plasma treatment) and modifies the surface. This may be explained by hydrogen diffusing into the grain boundaries, and acting later as a barrier toward oxygen, hereby preventing the metal, e.g. Cu, from oxidizing when exposed to oxidizing environment. However the hydrogen ions may also diffuse into the grains.
As a result, a long-term oxidation prevention, e.g. at least a few hours, e.g. 24 hours, may be obtained which allows storage of the metal surface in normal or ambient atmosphere (comprising e.g. air). This provides an extra degree of process freedom when compared to the prior art, since transportation and waiting cycles between metal, e.g. Cu, surface exposure and further processing such as e.g. wire bonding, are allowed. It is notable that preferably the wire bonding is performed in air at a temperature between room temperature and 250°C, more preferably between 100°C and 250°C during die attach and thermosonic wire bonding (see further).

After being treated with the method according to the second embodiment of the invention, the metal surface may be stored in an oxidising environment for a period of more than 8, more than 12, more than 24, more than 48 hours, without suffering from oxidation.

According to a third embodiment of the invention, another alternative method is provided for protecting a metal surface, the method comprising a combination of the methods described in the first and second embodiment. According to embodiments of the invention the method may comprise first treating the metal surface using the method according to the first embodiment (plasma aspect) followed by treating the metal surface using the method according to the second embodiment (sintering aspect). According to other, more preferred, embodiments, the method may comprise first treating the metal surface using the method according to the second embodiment of the invention (sintering aspect) followed by treating the method according to the first embodiment of the invention (plasma aspect).

The capabilities of long term oxidation prevention of the plasma treatment and/or sintering according to the first aspect of the present invention for metal, e.g. copper, bond pads has been tested on electroplated Cu on 200 mm silicon wafers. As a result, metal bonds could successfully be provided to the silicon wafer comprising the electroplated copper at least up to 10 days when the wafer was stored in an N₂ environment and at least up to 1 day when the wafer was exposed in ambient environment without any oxidation removal steps being necessary afterwards before performing a bonding step. With successfully provided is meant that after bonding the wire to the bond pad, a tight contact is obtained between the wire and the bond pad.

The methods described in the above embodiments may be used in processing of e.g. semiconductor devices. More particularly, the methods according to the above-described embodiments may be used for pre-treatment of metal bond pads on e.g. a semiconductor device before wire bonding. Hereinafter, wire bonding will be described by means of gold wires. As already mentioned, this is not intended to limit the invention in any way and other materials for forming wires may also be used with the present invention.

In a second aspect of the present invention, a method is provided for bonding a wire to a metal bond pad on a wafer. The method comprises treating the metal bond pad with the method according to any of the first, second or third embodiments and bonding a wire to the metal bond pad after having moved the wafer with the metal bond pad into an oxidizing environment.

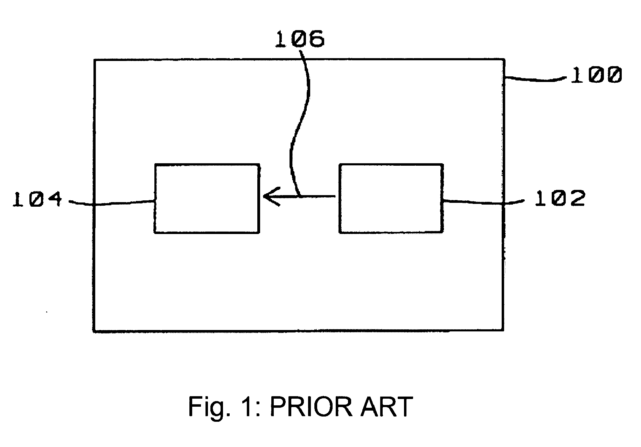

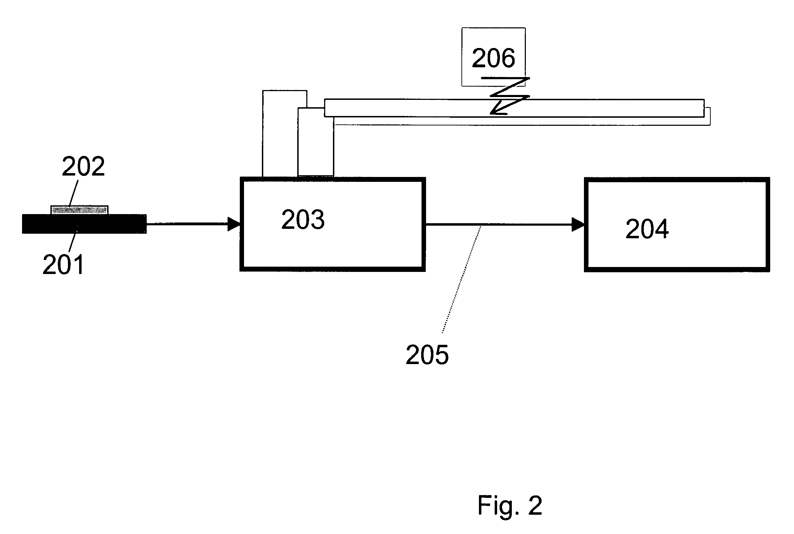

Fig. 2 illustrates an embodiment of a tool which can be used for performing the method according to the second aspect of the present invention by using the method according to the first embodiment. A wafer 201 comprising metal bond pads 202 is first provided into a plasma chamber 203 where it is treated using the method according to the first embodiment. Before the wafer 201 is transported to wire bonding equipment 204 (indicted by arrow 205), it may be stored in an oxidizing environment such as e.g. a storage room 206.

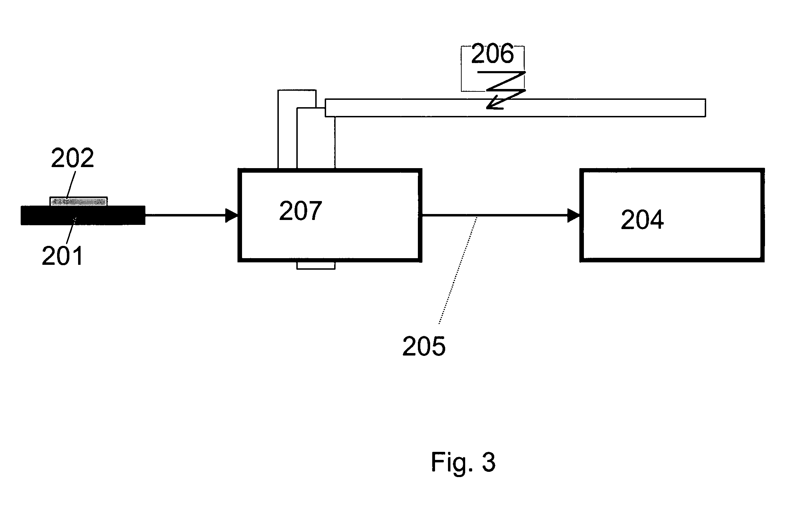

Fig. 3 illustrates an embodiment of a tool which can be used for performing the method according to the second aspect of the present invention by using the method according to the second embodiment. The tool is similar to the tool illustrated in Fig. 2 but the plasma chamber 203 is now replaced by an oven 207, for example an RTP oven.

Ultrasonic gold wire bonding is used to evaluate the effectiveness of the proposed sintering and/or plasma treatment techniques of the above-described embodiments. It has to be understood that this is only for an example and that other metals may also be used for the wire bonding.

Ball bonds were provided on the metal bond pads. Non-treated wafers showed a large number of non-stick ball bonds up to 90% (failed bonds), in comparison to 100% effective bonds realized on wafers treated using the method according to the first, second or third embodiments of the inventions. According to experiments, plasma conditions (like gas ratios, time, power) may be influencing the bondability of the metal, e.g. copper, surface. For the bonding performance evaluation the following criteria have been used:
- Amount of non-stick bond balls
- Ball shear force and Bond Shear Strength (= Ball shear force normalized by bond area value)
- Ball diameter and ball shape
- Bond performance time dependency

According to specific embodiments of the invention, wire bonding was carried out on a standard Wire Bonder (Delvotec 6200) equipped with a 60 kHz transducer. A gold wire for general bonding application of 25 µm diameter was used. Three level Design of Experiments (DOE, = experimental matrix) experiments with different bonding parameters (ultrasonic power, ultrasonic time and bonding force) were carried out to bond gold wire onto a plasma treated and/or sintered copper surface. Bond force, bond time and ultrasonic (US) power were varied for the process of wire bonding, whereas other parameters and settings were constant during all series of experiments. The bonding temperature was set to 150°C for all experiments. A bonding capillary for general wire bonding application with an 8° face angle (FA), 90° chamfer angle (CA) and a 100 µm tip was chosen.

As a result of plasma treatment according to the first embodiment of the present invention, or sintering treatment according to the second embodiment of the present invention, or combined method according to a third embodiment of the present invention, for protecting a metal surface against oxidation, the metal, e.g. copper, bond pads remain substantially oxide-free. With substantially oxide-free is meant that the degree of re-oxidation is low enough to allow a good wire bonding on the metal surface without any oxidation removal steps being necessary before the bonding step. With good wire bonding is meant that after bonding the wire to the bond pad, a tight contact is obtained between the wire and the bond pad. This would be for the whole period between starting the whole wafer's life time cycle, wafer's storage, up to completion of wire bonding process. It was evidenced that metal, e.g. copper, surfaces treated in such way exhibited enhanced resistance to oxidation during at least 1 day storage in ambient environment.
This means it can easily be stored in ambient or normal atmosphere conditions for 1 hour, 4 hours, 8 hours, 12 hours, 18 hours, 24 hours, 2 days or more. This is the case for metal surfaces treated by using the plasma treatment (first embodiment) or by using the sintered treatment (second embodiment) or by using the combination treatment (third embodiment).
If a very small amount of oxide would still be present on the metal bond pad, it would not negatively influence the wire bonding anymore. Very thin oxides would not prevent successful or good wire bonding to the wafer. The thicker the oxide on the wafer becomes, the more difficult wire bonding will be. Fresh Cu (as deposited onto the wafer) may have an oxide thickness of about 1 to 5 nm, which may still allow successful wire bonding. After deposition, the oxide grows rapidly and as from an oxide thickness of about 20 to 50 nm it may no longer be possible to obtain successful wire bonding to the wafer because of the too thick oxide being present.

An advantage of the method according to embodiments of the present invention is that a long term prevention of metal or metal based alloys as copper and copper based alloys from oxidation is achieved. This while the metal or metal based alloys as copper and copper based alloys are brought in an oxidising environment.
The storage life, self life, and thermal stability of metal surfaces are improved.
There is no metal, e.g. copper, consumption during surface treatment.
The plasma technique according to the first embodiment may be performed at CMOS compatible temperatures, which is e.g. lower than 450°C, or lower than 420°C, or lower than 400°C, or lower than 350°C, depending on the application. No foreign layer on top of the bond pad is required to perform metal protection, e.g. copper protection .
The method still allows and is suitable for thermosonic wire bonding techniques.

Moreover it is easy to integrate into existing factory automation platforms.

### Experiments

Table 2 illustrates the different condition sets used during experiments.

**Table 2: Different treatment condition sets.**

| Wafer's set | Plasma treatment | Sintering |
|---|---|---|
| 1 | 10s H₂/N₂ | No |
| 2 | 30s H₂/N₂ | no |
| 3 | 60s H₂/N₂ | no |
| 4 | 120s H₂/N₂ | no |
| 5 | 120s H₂/N₂ | 420°C |
| 6 | no | 420°C |
| 7 | no treatment | no |

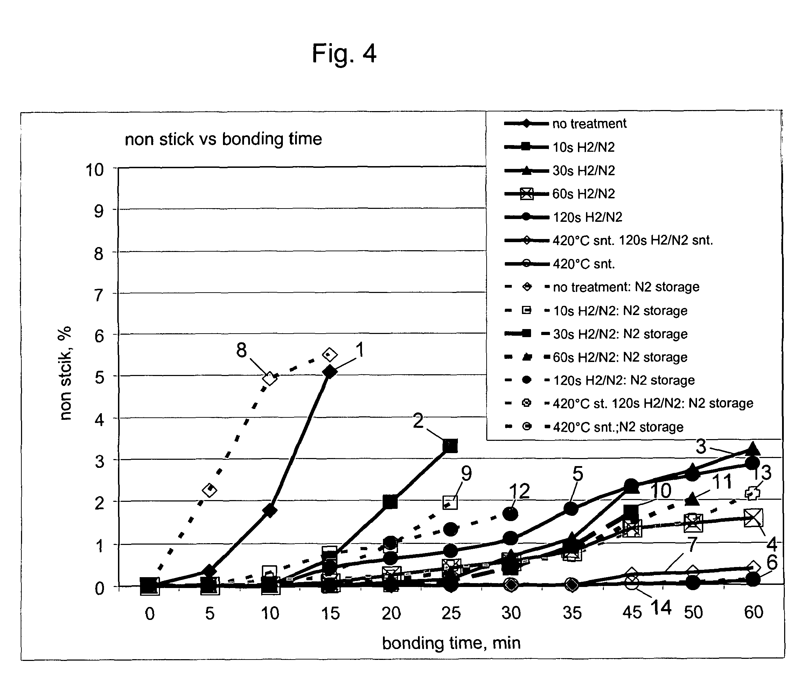

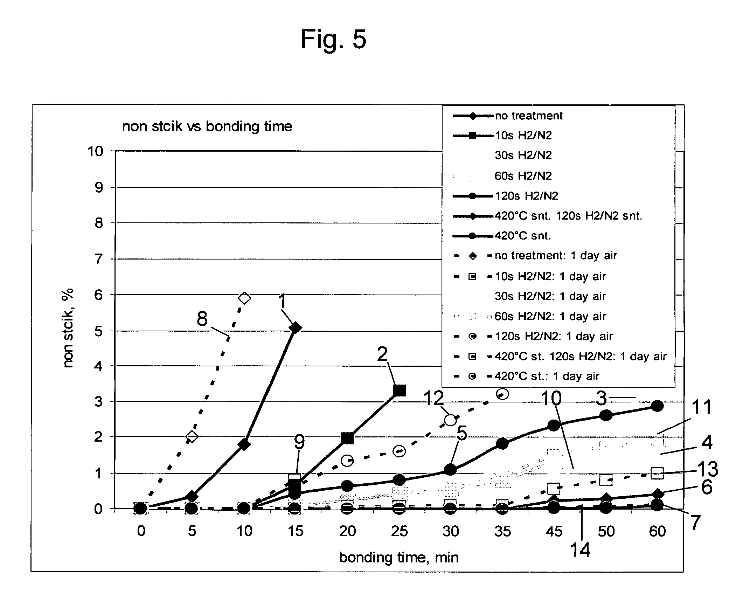

Results of bonding performance on non-treated samples are also plotted for reference purpose only (see Fig. 4).
Bonding performance was assessed in terms of non-stick bond balls occurrence (non-stick percentage). Non-stick, or bonds not sticking on the die, is a typical failure used for wire bonding process characterisation.
All plasma treated samples (according to the first embodiment) are performing much better than non-treated samples. Also differentiation between plasma treated samples has been observed. Non-treated samples (curve 1 in Fig. 4 and Fig. 5) have an order of magnitude larger amount of non-stick bond balls compared to samples treated in plasma only during 10 sec (curve 2 in Fig. 4 and Fig. 5). After 15 min. bonding the sample treated in plasma (according to the first embodiment) has 0.5% non-stick bond balls, whereas the non-treated sample has more than 5% non-stick bond balls, and for the best plasma treatment condition (i.e. for the plasma treatment after 30 and 60 sec. (respectively curve 3 and 4 in Fig. 4 and Fig. 5)) even 0% non-stick was encountered.
Increase plasma treatment duration from 10 sec to 60 sec results in an enhanced bonding performance; the amount of non-stick bond balls significantly decreases. Optimum bonding performance was demonstrated for the following plasma treatment conditions (see table 2): 2 (30 sec) and 3 (60 sec) (see respectively curve 3 and 4 in Fig. 4 and Fig. 5). Based on that, it can be concluded that plasma treatments in a time range between 30 (curve 3 in Fig. 4 and Fig. 5) and 120 (curve 5 in Fig. 4 and Fig. 5) seconds, more preferably between 30 (curve 3 in Fig. 4 and Fig. 5) and 60 sec (curve 4 in Fig. 4 and Fig. 5) are the most interesting from practical point of view and give the best wire bonding performance, whereas further increasing the plasma treatment duration did not bring any performance improvement and saturation followed by deterioration bonding performance. Bonding performance after 120 sec (curve 5 in Fig. 4 and Fig. 5) of plasma treatment is worse than bonding performance after 30 and 60 sec of plasma treatment respectively (see respectively curve 3 and 4 in Fig. 4 and Fig. 5). The range of 60 to 120 seconds is though also interesting.
Influence of wafer's storage at inert atmosphere (10 days in N₂) on bonding performance has been studied. The dashed series of lines on Fig. 4 (curves 8 to 14) illustrate bonding performance on the wafer's set (table 2) additionally to plasma treatment according to the first embodiment subjected to storage during 10 day at N₂ environment. Storage at N₂ deteriorates bonding on non-treated wafers (curve 8); contrary to that it does bring significant changes in bonding performance on plasma treated wafers (curve 9 (10 sec), curve 10 (30 sec), curve 11 (60 sec) and curve 12 (120 sec)), in accordance with the present invention. Based on that observation it is concluded that proper storage conditions will not change wafer's bonding performance.
Bonding performance on wafers directly after plasma treatment and after 24 h air exposure (dashed lines in Fig. 5, curves 8 to 14) has also been compared. On all treated samples, except at 10 sec (curves 9 to 14 in Fig. 5), a slight difference is observed for plasma treated samples (curve 9 (10 sec), curve 10 (30 sec), curve 11 (60 sec) and curve 12 (120 sec)), however it is within an error range of ± 1 %.
Significant deterioration occurred on non plasma treated wafers (curve 8 in Fig. 5) and a quite remarkable difference is obtained with regard to 10 sec plasma treated wafers (curve 9 in Fig. 5).

On figures 4 and 5 additionally to the results for plasma treated samples, results for samples subjected to sintering (table 2) were plotted. These samples in terms of non-stick bond ball features yield still much better as any plasma treated sample. Also they demonstrated excellent resistance to N₂ storage (see curve 14 in Fig. 4) and 1 day exposure to air (see curve 14 in fig. 5). Samples treated with both the plasma treatment (first embodiment) and sintering treatment (second embodiment) showed very good non-stick bond ball characteristics both directly after treatment (see curve 6 in Fig. 4 and Fig. 5) and after 1 day storage in air (see curve 13 in Fig. 5).

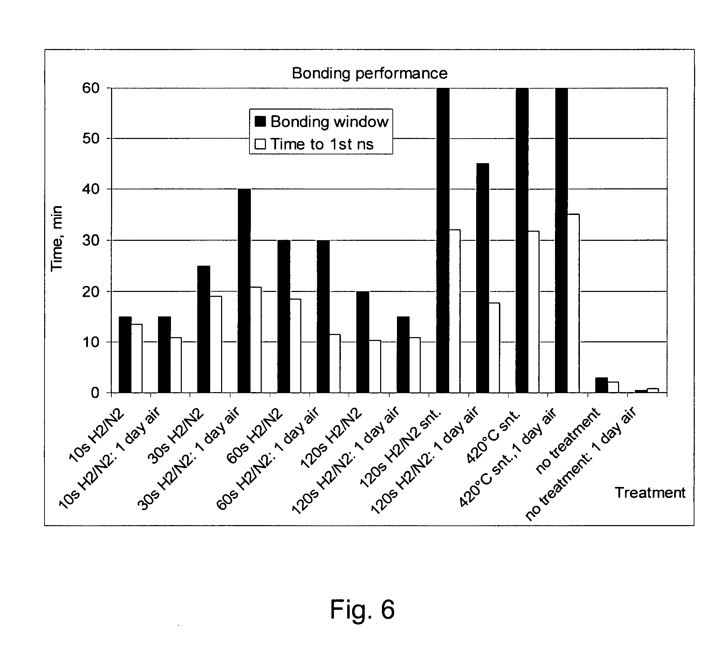

Fig. 6 describes bonding performance in terms of a bonding window and time to first non-stick.
"Time to first non-stick" is a bonding response solely caused by wafer conditions excluding any visual surface defects and contamination except defects due to thermal metal, e.g. copper, oxidation and/or any degradation phenomena or phenomena related to these processes, and is a time when the first non-stick occurs.
The "bonding window" is a bonding response solely caused by wafer conditions; it is a time period in which only a specified amount of non-stick events may occur.
Bonding performance in terms of "Time to first non-stick" and "Bonding window" have similar trends. Non-treated samples have very short bonding windows and first non-stick occurs very early. From practical point of view non-treated samples are not suitable for wire bonding, whereas already a short plasma treatment of 10 sec improves bonding performance significantly. Samples treated during 30 to 60 sec have the largest bonding window. Sintered samples exhibit even a broader window.

## Claims

1. A method for protecting a metal surface comprising the steps of
a. providing the metal surface within a plasma chamber;
b. producing a hydrogen comprising plasma within said plasma chamber;
c. treating said metal surface with said hydrogen comprising plasma whereby the metal surface is at a temperature above 150°C for removing oxides present at the metal surface and for hydrogenating the metal surface; and
d. removing said metal surface from said plasma chamber into an oxidising environment.

2. A method according to claim 1, wherein the temperature is between 150°C and 400°C.

3. A method according to claim 1 or 2, wherein said metal surface comprises Cu or Ag.

4. A method according to any of claims 1 to 3, wherein said plasma is formed from a plasma gas, the plasma gas comprising H₂ and/or NH₃.

5. A method according to claim 4, wherein a fraction of plasma gas comprising H₂ and/or NH₃ is between 100% and 20%, more preferably between 90% and 70%.

6. A method according to any of claims 1 to 5, wherein said plasma is formed of a plasma gas, the plasma gas comprising N₂, O₂, Ar or He, or other noble gases, or a combination of the aforementioned gases.

7. A method according to claim 6, wherein the fraction of plasma gas comprising N₂, O₂, Ar or He, or other noble gases or a combination of the aforementioned gases is between 0% and 30%, preferably between 10 and 30%.

8. A method according to any of the previous claims, whereby the method furthermore comprises storing said metal surface in an oxidising environment for a period of more than 24 hours.

9. A method according to any of the previous claims, wherein the hydrogen comprising plasma is generated by an Inductively coupled Plasma - Reactive ion etching device.

10. A method according to claim 9, wherein a power supplied to a coil of the Inductively coupled Plasma - Reactive ion etching device is between 300 to 1000 W.

11. A method according to claim 9, wherein direct power parameter of the Inductively coupled Plasma - Reactive ion etching device is between 50 and 250 W.

12. A method according to any of claims 1 to 8, wherein said hydrogen comprising plasma is generated by microwave downstream plasma equipment.

13. A method according to claim 12, wherein a power for microwave downstream plasma is between 200 and 3000 W.

14. A method according to any of the previous claims, wherein treating said metal surface with said hydrogen comprising plasma has a duration between 30 and 120 seconds, preferably between 60 and 120 seconds.

15. A method according to any of the previous claims, wherein injection of gas into the plasma chamber for forming the plasma has a flow between 50 sccm and 600 sccm.

16. A method for protecting a metal surface comprising the steps of
a. providing a substrate comprising a metal surface in a chamber of an oven,
b. heating the substrate to a temperature in the range of 150°C to 600°C , more preferably in the range of 300°C to 500°C, more preferably in the range of 400°C to 450°C, in a reducing gas atmosphere; and
c. removing said substrate from said chamber into an oxidising environment.

17. A method according to claim 16, wherein the reducing gas comprises free hydrogen or chemically bonded hydrogen.

18. A method according to claim 16 or 17, wherein said reducing gas comprises H₂, N₂, Ar or He, NH₃ or other inert gases or gas compositions.

19. A method according to claim 16 or 17, wherein said forming gas comprises only H₂ and N₂.

20. A method according to claim 19, wherein said amount of N₂ in the forming gas is between 98 % and 0%.

21. A method according to claim 19 or 20, wherein said amount of H₂ is between 2% and 30%, or between 2% and 20%, or between 2% and 15%, or between 2% and 10%.

22. A method according to any of claims 16 to 21, furthermore comprising storing said metal surface in an oxidising environment for a period of more than 24 hours.

23. A method according to any of claims 16 to 22, wherein said oven is an RTP oven.

24. A method according to any of claims 16 to 23, wherein heating the substrate has a duration between 5 and 60 minutes, more preferably between 10 and 60 minutes, even more preferably between 15 and 25 minutes.

25. A method for protecting a metal surface, comprising
a. treating the metal surface using a method according to any of claims 16 to 23, and
b. treating the metal surface using a method according to any of claims 1 to 15.

26. Use of the method according to any of the previous claims in the manufacturing of semiconductor devices.

27. A method for bonding a wire to a metal bond pad on a wafer, the method comprising the steps of:
a. treating the metal bond pad using the method according to any of claims 1 to 25, and
b. bonding a wire to said metal bond pad after having moved said wafer into an oxidising environment.

28. The method according to claim 27, wherein said metal bond pad comprises a material selected from the group comprising Al, Al-Cu, and Cu, and wherein said wire comprises a material selected from the group comprising Au, Ag, a copper alloy and copper.

29. The method according to claim 27, wherein said wire comprises Cu coated with Au, Cu coated with Pd or Cu coated Ag .

30. The method of any of claims 27 to 29, further including the step of masking said wafer to expose said metal bond pad before said hydrogen-plasma production step.
